# EUROPEAN PATENT APPLICATION

(11) **EP 0 926 788 A1**
(43) Date of publication of application: **30.06.1999**
(21) Application number: 98123504.7
(22) Date of filing: 15.12.1998
(51) Int. Cl.: H01S 3/10, H01S 3/106

(54) **Optical assembly for laser diode**

(30) Priority: 24.12.1997 IT VR970123
(71) Applicant: TTS S.r.l., 38068 Roverto (Prov. of Trento) (IT)
(72) Inventor: Aita, Massimo, 38060 Villalagarina (Prov. of Trento) (IT); Aita, Francesco, 38060 Trambileno (Prov. of Trento) (IT)
(74) Representative: Modiano, Guido, Dr.-Ing.

(57) **Abstract**

An optical laser diode assembly which comprises: a coherent light source (2) based on a laser diode; a power source (3) for the light source (2); an optical cavity (4) provided with reflective internal surfaces and inside which the light source (2) can be located; a support (5) which can be inserted in the optical cavity (4) and is arranged to support a plano-convex lens (6), rigidly secured thereto and designed to receive coherent light rays from the light source (2); a container (7) at least for the optical cavity (4) and the lens support (5). The lens support (5) and the optical cavity (4) are movable with respect to each other between a position of minimum distance and a position of maximum distance between the lens (6) and the light source (2) to modify the divergence of the light rays from the lens (6).

## Description

The present invention relates to a laser-diode optical assembly, particularly for shooting training and practice.

Devices and means for simulating firing of weapons by means of an emitter which emits a coherent light ray or beam against a preset target equipped with receiving sensors arranged to signal hits or operating together with vision systems which control the hit target and process its result are generally known in the art.

In order to correctly receive the beam emitted by the emitter, the sensors are suitably set to wavelength and/or frequency thereof, so as to avoid any external interference due to the presence of other light sources.

As far as sensor sensitivity is concerned, most important is the energy intensity or density parameter of the light beam, whereas simulation accuracy requires the emitter system to be properly collimated with the sights of the firearm to which it is applied.

Optical assemblies connected by cable to processing units or radio-linked assemblies equipped with detectors which monitor the target by means of a television camera, are currently used.

Optical assembly systems are also used which control the cross-section of the light beam with various combinations of corrective lenses in order to obtain narrow cross-sections in combination with targets having large light-sensitive surfaces or wider and divergent cross-sections in combination with targets having one or more small cross-sections.

A system is also known which by combining complex geometric shapes of an optical cavity and lenses with assemblies of diffuser elements causes the emission of beams having a wide cross-section at close range with respect to the targets and of controlled beams with a medium cross-section at longer ranges.

The cross-section of a light beam is very important in relation to both the distance of the surface to be hit and the application of the simulation, which can relate to impulsive firing and aimed firing.

The said light beam is emitted by a laser which is usually a semiconductor-type laser with injection of electrical charges by means of a DC circuit. The semiconductor laser is very practical in terms of overall dimensions and thus its use is preferred with respect to other laser types. However, it has the drawback that it emits a beam which has a high divergence, is elliptical and must, therefore, be adequately narrowed and conveyed by means of optical cavities which terminate with various types of lens.

The limitations for the use of optical systems for correcting a laser beam are due to the above-mentioned choices, which do not always match the operating requirements of a proper shooting training.

As a matter of fact, if systems which make it possible to obtain small laser beam cross-sections are used, the safety threshold is easily exceeded. Moreover, with these systems it is difficult and expensive to combine and use targets having large light-sensitive surfaces, such as mobile portable shooting ranges.

However, when using systems which make it possible to obtain wider and divergent laser beam cross-sections or controlled cross-sections, the result does not always correspond to a simulation of real firing that a laser beam must represent depending upon the operating ranges.

Furthermore, currently known devices are characterized by the fact that the radiation beams are always preset and fixed for each instrument.

The main object of the present invention is to provide an optical assembly for laser diode which is designed to vary the angle of divergence of an emitted light beam in order to optimize the cross-section of the beam that can be used at various (short, medium and long) target ranges.

Another object of the present invention is to provide a laser-diode optical assembly which is easy to collimate with the sights of a firearm and can be quickly adjusted by the shooter to perform shooting training without firing bullets.

Another object of the present invention is to provide a laser-diode optical assembly which can be used with a system of reacting or collapsable dummy targets equipped with sensors and arranged at any distance within the range within which energy can be detected by the said sensors.

More particularly, the dummy targets can be of the retracting type, e.g. as disclosed in Italian Patent no. 1253143.

Another object of the present invention is to provide a laser diode optical assembly which has a low production cost so as to be advantageous also from the economic point of view.

These and other objects which will become better apparent hereinafter are achieved by an optical assembly for laser diode, which comprises:
-- a laser diode coherent-light source;
-- a power source for the said light source;
-- an optical cavity having reflecting internal surfaces and locating the said light source;
-- a support in said optical cavity arranged to support a plano-convex lens for receiving coherent light rays from the said light source;
-- a container for said optical cavity and said lens support;
   and is characterized in that the said lens support and said optical cavity are movable one with respect to the other from a position of minimum distance and a position of maximum distance between said lens and said light source in order to modify the divergence of the light rays exiting from the said lens.

Advantageously, the said light source is connected to an electronic control unit which is arranged to control the power level and the frequency modulation of said coherent light source.

Further aspects and advantages of the present invention will become better apparent from the following detailed description of some at present preferred embodiments given by way of nonlimiting examples with reference to the accompanying drawings, wherein:

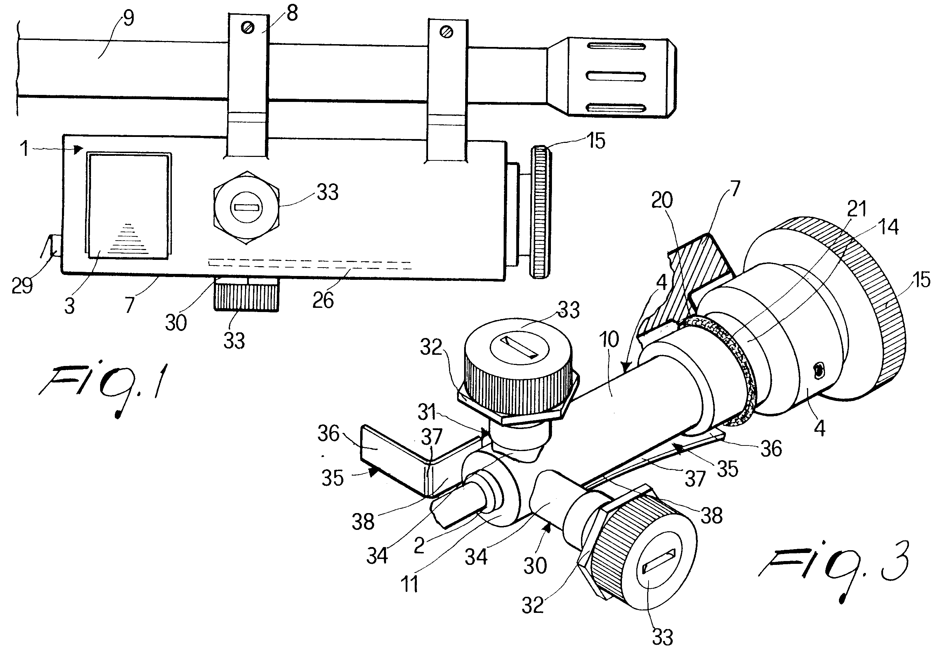

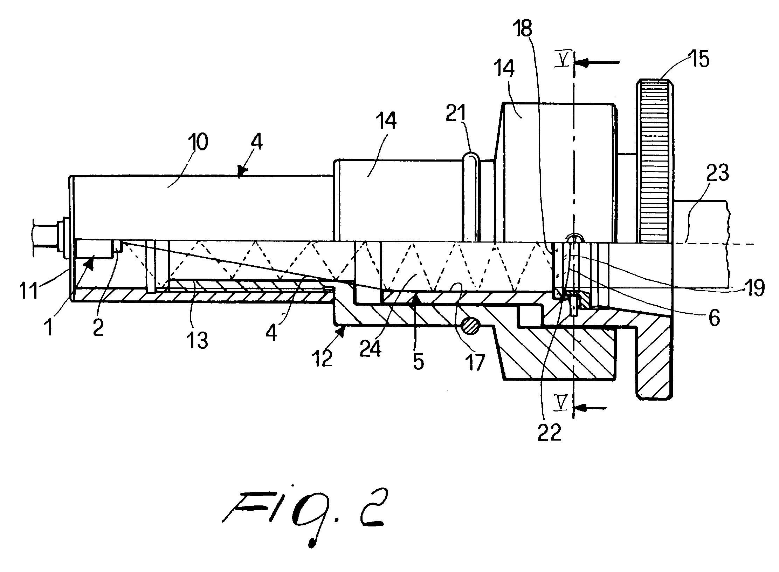

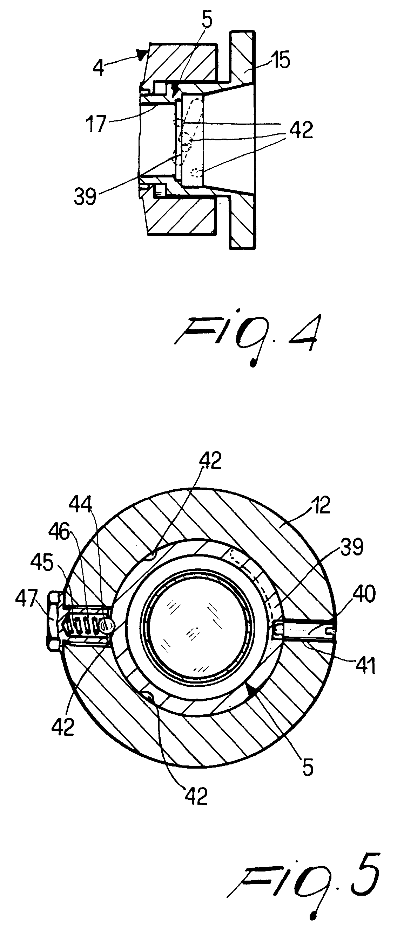

Figure 1 is a side elevation view of an optical assembly provided with a container which can be secured to the barrel of a firearm;
Figure 2 is a view in enlarged scale and half in cross-section of an optical assembly without the container, while emitting a laser beam;
Figure 3 is a perspective view slightly from above of the optical assembly of Figure 1 without container;
Figure 4 is a side cross-sectional elevation view of portion of an optical cavity and of a lens support; and
Figure 5 is a front view of Figure 4.

In the accompanying drawings, identical or similar parts or components have been designated by the same reference numerals.

With reference to the above-listed Figures, the numeral 1 generally designates an optical assembly for a laser diode which comprises: a coherent light source 2, preferably a junction diode; a power source 3 for the said light source 2; an optical cavity 4 which has reflecting internal surfaces and inside which the said light source 2 can be secured; a support 5, insertable in said optical cavity 4 and arranged to support a plano-convex lens 6 which can be rigidly coupled thereto; a container 7 for the optical assembly 1 and the lens support 5; and attachment means 8 designed to secure the said container to a firearm 9.

According to the illustrated embodiment, the optical cavity 4 can include two parts: a hollow cylinder 10, on the bottom 11 of which a junction diode 2 can be located to act as radiation source; and a collimation tube 12, which can be partly inserted into the cylinder 10. The tube 12 comprises a portion 13, which has a smaller diameter and can be inserted in the cylinder 10, and a portion 14, which has a larger diameter and is arranged to accommodate the lens support 5.

The support 5 is formed by a tubular portion 17 which can be slidingly inserted in the portion 14 of the tube 12 and by an annular end protrusion or flange 15 which protrudes, in use, from the collimation tube 12. At the flange 15, inside the tube 17, the lens 6, which has a flat surface 18 facing the diode 2 and an outer convex surface 19 can be located.

The outside of the portion 14 can be placed in a corresponding cavity 20 of the container 7, so as to rigidly couple the optical cavity 4 thereto. An annular gasket 21 (Figure 3) can be provided between the inner surface of the container 7 and the outer surface of said portion 14.

The securing means for rigidly coupling the support 5 to the collimation tube 12 can be a threaded coupling, whereas the engaging means for coupling the lens 6 to the support 5 can be of the interlock type 22. In use, the optical axis 23 of the lens 6 (Figure 2) coincides with the propagation axis of the light ray 24, which owing to the fact that all the internal surfaces of the optical cavity 4 and the support 5 are reflecting, is conveyed onto the lens 6.

The junction laser diode 2 can be electrically conected to an electronic control unit 26 which is designed to control its power level and its frequency modulation. In turn, the said card 26 can be electrically connected to a power source, for example a low-voltage DC power supply battery 3. The said battery can be located inside the container 7 and connected to a switch 29 accessible from outside.

The optical cavity 4 and the lens support 5 rigidly coupled thereto are adjustable with respect to the container 7 owing to the action of a windage adjustment screw 30 and an elevation adjustment screw 31 (Figure 3). Each of said screws can engage with a respective female thread 32 which is integral with the container 7 and has its head 33 protruding from the container, whereas its stem 34 touches and urges against the outside of the optical cavity 4.

Resilient loading means, e.g. resiliently deformable laminae 35, are rigidly connected to the container 7 on the opposite side of the optical cavity 4 with respect to each screw 30 or 31. The said laminae have an end 36 rigidly coupled to an internal surface of the container 7 and are rounded at their other free end 38 which rests on the outside of the optical cavity 4 in order to resiliently contrast the thrust that can be applied by the corresponding screw 30 or 31.

According to the embodiment shown in Figures 4 and 5, the optical cavity 4 is obtained in one piece and the lens support 5 is gauged outside for being slidingly inserted into said cavity 4. The outer surface of the said support has a recess 39 which is inclined with respect to the axis of the support 5 and is arranged to slidingly engage a pin 40 which can engage with a corresponding threaded bore 41 in the optical cavity 4. The said outer surface also has, on the opposite side thereof, seats or recesses 42 which are designed to accommodate a retention ball 44 loaded by a spring 45 which can be located in a corresponding through opening 46 of the optical cavity 4 and compressed by the action of a screw 47.

Partial screwing of the flange 15 in one direction or the other owing to the sliding engagement of the pin 40 with the recess 39 causes a corresponding micrometric translatory motion of the lens 6 with respect to the light source 2. This condition makes it possible to vary the position of the focus of the lens 6 with respect to the light source 2, thereby controlling the divergence of the emitted light beam and in particular reducing its cross-section if the distance between the lens 6 and the source 2 increases.

Engagement of the ball 44 with one of the three seats or recesses 42 of the support 5 results in a temporary locking thereof. Thus, according to this embodiment, the distance between the lens 6 and the light source 2 can take three preset discrete values.

Relative translatory motion between the lens 6 and the light source 2 can also occur by virtue of a source of motion, e.g. a step motor (not shown) which can be operatively connected to the flange 15 or is arranged to screw or unscrew the support 5 inside the optical cavity 4. In this manner, it is possible to obtain a substantially continuous sequence of values of distances between the lens 6 and the light source 2, with a consequent very precise control of the divergence of the beam in relation to the distance of the target and to the type of application.

It is also possible to control the operation of the motor by connecting it to the electronic unit or board 26 so that according to the distance, which can be measured directly by the laser beam, the said control unit 26 autonomously generates a signal for the motor to correspondingly adapt the distance between the lens 6 and the light source 2.

Instead of providing the lens 6 so that it can be moved with respect to the diode 2, it is of course possible to move the diode 2 with respect to the lens 6 or to cause them both to move with respect to each other.

Activation of the junction diode 2 can occur by operating the switch 29 or owing to the noise produced by the firing of a blank cartridge from the firearm, if a microphonic and/or piezoelectric sensor arranged to forward dielectric pulses to the said diode 2 is provided.

The junction diode 2 can emit a coherent light beam whose wavelength is in the visible range or in the near, medium or far infrared range.

The container 7 can be preferably made of a composite impact-resistant plastic material or of externally treated metal and can be rigidly secured to the weapon 9 by means of collars or clamps 8 rigidly fixed thereto.

The above described invention is susceptible to numerous modifications and variations within the scope as defined by the appended claims.

The disclosures in Italian Patent Application No. VR97A0000123 from which this application claims priority are incorporated herein by reference.

Where technical features mentioned in any claim are followed by reference signs, those reference signs have been included for the sole purpose of increasing the intelligibility of the claims and accordingly, such reference signs do not have any limiting effect on the interpretation of each element identified by way of example by such reference signs.

## Claims

1. A laser-diode optical assembly, comprising:
-- a laser diode coherent-light source (2);
-- a power source (3) for the said light source (2);
-- an optical cavity (4) having reflecting internal surfaces and locating the said light source (2);
-- a support (5) in said optical cavity arranged to support a plano-convex lens (6) for receiving coherent light rays from the said light source (2);
-- a container (7) for at least said optical cavity (4) for said lens support (5);
and characterized in that the said lens support (5) and said optical cavity (4) are movable one with respect to the other from a position of minimum distance and a position of maximum distance between said lens (6) and said light source (2) , in order to modify the divergence of the light rays exiting from the said lens (6).

2. An optical assembly according to claim 1, characterized in that it comprises an electronic control unit (26) arranged to control the power level and frequency modulation of the said coherent light source (2).

3. An optical assembly according to claim 2, characterized in that it comprises a source of motion controlled by the said electronic control unit (26) and is designed to produce the relative movement of said lens (6) with respect to said light source (2).

4. An optical assembly according to any one of the preceding claims, characterized in that the said lens (6) or lens support (5) can be inclined on a windage plane and on an elevation plane with respect to said container (7).

5. An optical assembly according to any one of the preceding claims, characterized in that said coherent light source (2) comprises a junction diode with charge injection pumping effect.

6. An optical assembly according to any one of the preceding claims, characterized in that it comprises a sensor means designed to act in response to shot in salves of a firearm (9) thereby energizing the said light source (2).

7. An optical assembly according to claim 6, characterized in that said sensor means is of piezoelectric type.

8. An optical assembly according to claim 6, characterized in that said sensor means is of the microphonic type.

9. An optical assembly according to any one of the preceding claims, characterized in that the distance between said lens (6) and said light source (2) is variable with preset positions.

10. An optical assembly according to claim 9, characterized in that the outer surface of said lens support (5), insertable into the said optical cavity (4), has recesses (39) with which a holding means (40) rigidly securable to the said optical cavity (4) and resiliently loaded can engage.

11. An optical assembly according to claim 10, characterized in that the said holding means comprises a resiliently loaded ball (44).

12. An optical assembly according to any one of the preceding claims 1 to 11, characterized in that said lens support (5) can be rigidly secured to the said optical cavity (4) by means of a threaded coupling.

13. An optical assembly according to any one of the preceding claims, characterized in that it has a recess (39) in the outer surface of said support (5) which is inclined with respect to the axis of said support (5), and a pin (40) located in a seat (41) of said optical cavity (4) so as to slidingly engage the said recess (39), whereby an angular movement of the said support (5) results in a respective translatory motion of the support (5) with respect to said light source (2).

14. An optical assembly according to any one of the preceding claims, characterized in that said optical cavity (4) comprises two rigidly assemblable portions (10,12), one of which is arranged to locate the said light source (2) and the other is designed to accommodate the said support (5).

15. An optical assembly according to any one of the preceding claims, characterized in that said coherent light source (2) has a wavelength within the visible light range or within the near, medium or far infrared range.

16. An optical assembly according to any one of the preceding claims, characterized in that said container (7) comprises a manual switch (29) for energizing the said light source (2).

17. An optical assembly according to one or more of the preceding claims, characterized in that it comprises means (8) for securing the container (7) to a firearm (9).
